# EUROPÄISCHE PATENTSCHRIFT

(11) **EP 4 176 483 B1**
(45) Veröffentlichungstag und Bekanntmachung des Hinweises auf die Patenterteilung: **21.05.2025**
(21) Anmeldenummer: 21734805.1
(22) Anmeldetag: 18.06.2021
(51) Int. Cl.: G01R 31/52, H01M 10/42, H01M 10/48

(54) **ELEKTRISCHES GERÄT UND VERFAHREN ZUM BETRIEB EINES ELEKTRISCHEN GERÄTS**
ELECTRICAL DEVICE AND METHOD FOR OPERATING AN ELECTRICAL DEVICE
DISPOSITIF ÉLECTRIQUE ET PROCÉDÉ DE FONCTIONNEMENT D'UN DISPOSITIF ÉLECTRIQUE

(30) Priorität: 03.07.2020 DE 102020208356
(43) Veröffentlichungstag der Anmeldung: 10.05.2023
(73) Patentinhaber: Robert Bosch GmbH, 70442 Stuttgart (DE)
(72) Erfinder: SEGRET, Mickael, 70569 Stuttgart (DE); KLEE, Christoph, 70599 Stuttgart (DE); SEIBERT, Marc-Alexandre, 70567 Stuttgart (DE)
(86) Internationale Anmeldenummer: PCT/EP2021/066592
(87) Internationale Veröffentlichungsnummer: WO 2022/002639

(56) Entgegenhaltungen:
- DE-A1- 102008 043 473
- US-A1- 2016 313 270
- US-A1- 2018 198 294

## Beschreibung

### Stand der Technik

Die Erfindung geht von einem elektrischen Gerät und einem Verfahren zum Betrieb eines elektrischen Geräts aus.

Ein elektrisches Gerät ist durch konstruktive Maßnahmen gegen Schmutz oder Feuchtigkeit geschützt.

Aus US 2016/313270 A1 ist bereits ein elektrisches Gerät gemäß dem Oberbegriff von Anspruch 1 bekannt.

In DE 10 2016 207 566 A1 wird ein Akkupack beschrieben, der sich unter bestimmten Voraussetzungen selbst entladen kann.

US 2018/198294 A1 offenbart ein Akkupack für Werkzeuge.

DE 10 2008 043473 A1 offenbart eine Brennstoffzelle mit einer Feuchtesensorrvorrichtung.

Es ist schwierig, derartige Maßnahmen gegen Schmutz oder Feuchtigkeit über eine Lebenszeit des Produktes aufrecht zu erhalten. Beispielsweise können mechanische Einflüssen einen Schutz, den konstruktive Maßnahmen bieten, beschädigen. Des Weiteren kann Schmutz oder Feuchtigkeit beispielsweise im Fall eines Defekts eines Elektrolytkondensators oder einer Akkuzelle des Akkupacks, die Elektrolyt enthält, auch im Inneren des elektrischen Geräts entstehen.

### Offenbarung der Erfindung

Durch ein elektrisches Gerät und ein Verfahren zum Betrieb des elektrischen Geräts gemäß den unabhängigen Ansprüchen, wird eine Betriebssicherheit des elektrischen Geräts hinsichtlich Schmutz oder Feuchtigkeit verbessert.

Das elektrische Gerät weist ein Gehäuse mit einem ersten außenliegenden Kontakt und einem zweiten außenliegenden Kontakt zur Energieversorgung des elektrischen Geräts auf, wobei das elektrische Gerät im Gehäuse einen ersten Leiter, einen zweiten Leiter und eine Auswerteeinrichtung umfasst, wobei der erste Leiter mit einem ersten Kontakt für ein erstes Potential elektrisch verbunden ist, wobei der zweite Leiter mit einem zweiten Kontakt für ein zweites, vom ersten Potential verschiedenes Potential elektrisch verbunden ist, wobei der erste Leiter und der zweite Leiter mit der Auswerteeinrichtung elektrisch verbunden sind, wobei der erste Leiter und der zweite Leiter derart angeordnet sind, dass eine elektrische Verbindung des ersten Leiters und des zweiten Leiters durch Schmutz oder Feuchtigkeit im Gehäuse mittels der Auswerteeinrichtung detektierbar ist. Insofern wird leitfähiger Schmutz oder Feuchtigkeit unabhängig davon detektierbar, ob ein Schaden entstanden ist oder nicht. Der zweite Leiter ist über einen Widerstand mit einem Eingang der Auswerteeinrichtung zur Detektion von Schmutz oder Feuchtigkeit elektrisch verbunden. Dieser Widerstand stellt einen Schutzwiderstand für die Auswerteeinrichtung dar. Die Auswerteeinrichtung ist ausgebildet, einen Fehlerfall zu erkennen, wenn eine elektrische Verbindung des ersten Leiters und des zweiten Leiters durch Schmutz oder Feuchtigkeit detektiert wurde, wobei die Auswerteeinrichtung ausgebildet ist, das elektrische Gerät im Fehlerfall zu deaktivieren. Dies erhöht die Betriebssicherheit zusätzlich. Der erste Leiter und der zweite Leiter sind zwei benachbarte, gegen eine Umgebung der Leiterplatte nicht isolierte Leiterbahnen.

Vorzugsweise ist der zweite Leiter über einen Widerstand mit dem zweiten Kontakt und einem Eingang der Auswerteeinrichtung für eine Versorgungsspannung elektrisch verbunden. Dieser Widerstand kann ein Pull-Up Widerstand sein, an dem im Betrieb des elektrischen Geräts die Versorgungsspannung der Auswerteeinrichtung anliegt. Die Versorgungsspannung stellt in diesem Fall das zweite Potential dar. Dadurch ist Schmutz oder Feuchtigkeit kostengünstig detektierbar.

Vorzugsweise ist der erste Leiter mit einem Eingang der Auswerteeinrichtung für ein Bezugspotential elektrisch verbunden. Das Bezugspotential stellt in diesem Fall das erste Potential dar. Dadurch ist ein Potentialunterschied für eine Detektion von Schmutz oder Feuchtigkeit kostengünstig darstellbar.

Vorzugsweise sind der erste Leiter und der zweite Leiter elektrisch isoliert voneinander und in einem Bereich zumindest abschnittsweise benachbart und unisoliert zueinander angeordnet. Dies ermöglicht es Schmutz oder Feuchtigkeit in vorgegebenen Abschnitten zu detektieren.

Vorzugsweise umfasst das elektrische Gerät eine Akkuzelle und eine Entladeeinrichtung, wobei die Auswerteeinrichtung ausgebildet ist, die Akkuzelle im Fehlerfall mit der Entladeeinrichtung zu entladen. Dies erhöht die Betriebssicherheit eines mit einer Akkuzelle betriebenen elektrischen Geräts zusätzlich.

Vorzugsweise umfasst das elektrische Gerät eine Ladeeinrichtung für eine Akkuzelle, wobei die Auswerteeinrichtung ausgebildet ist, die Ladeeinrichtung im Fehlerfall zu deaktivieren oder wobei die Auswerteeinrichtung ausgebildet ist, ein Laden einer Akkuzelle durch eine Ladeeinrichtung im Fehlerfall zu verhindern. Dies erhöht die Betriebssicherheit einer Ladeeinrichtung zusätzlich.

Vorzugsweise sind im elektrischen Gerät verschiedene Paare von erstem Leiter und zweitem Leiter elektrisch isoliert voneinander angeordnet, die mit unterschiedlichen Eingängen der Auswerteinrichtung elektrisch verbunden sind, wobei die Auswerteinrichtung ausgebildet ist, eine Anzahl von Paaren zu bestimmen, für die die elektrische Verbindung detektiert wird, wobei die Auswerteinrichtung ausgebildet ist, einen Fehlerfall des elektrischen Geräts abhängig von der Anzahl zu bestimmen. Dies ermöglicht eine Erkennung eines Grades einer Beeinträchtigung der Betriebssicherheit des elektrischen Geräts durch Schmutz oder Feuchtigkeit.

Vorzugsweise sind im elektrischen Gerät ein erster Leiter und eine Mehrzahl von zweiten Leitern benachbart zueinander und elektrisch isoliert voneinander angeordnet, wobei die Auswerteinrichtung ausgebildet ist, eine Anzahl von zweiten Leitern zu bestimmen, für die die elektrische Verbindung des ersten Leiters mit dem zweiten Leiter detektiert wird, wobei Auswerteinrichtung ausgebildet ist, einen Fehlerfall des elektrischen Geräts abhängig von der Anzahl zu bestimmen. Dies ermöglicht eine Erkennung einer Größe oder einer Art einer Verschmutzung oder einer Menge Feuchtigkeit, die im elektrischen Gerät vorhanden ist.

Das Verfahren zum Betrieb des elektrischen Geräts in dem wenigstens ein erster Leiter, wenigstens ein zweiter Leiter und eine Auswerteeinrichtung angeordnet sind, wobei der wenigstens eine erste Leiter mit einem Kontakt für ein erstes Potential elektrisch verbunden ist, wobei der wenigstens eine zweite Leiter mit einem Kontakt für ein zweites, vom ersten Potential verschiedenes Potential elektrisch verbunden ist, wobei das elektrische Gerät mittels der Kontakte mit Energie versorgt wird, wobei der wenigstens eine erste Leiter und der zweite Leiter mit der Auswerteeinrichtung elektrisch verbunden sind, wobei der wenigstens eine erste Leiter und der wenigstens eine zweite Leiter derart angeordnet sind, dass eine elektrische Verbindung wenigstens eines ersten Leiters und wenigstens eines zweiten Leiters durch Schmutz oder Feuchtigkeit mittels der Auswerteeinrichtung detektierbar ist, sieht vor, dass wenn eine elektrische Verbindung wenigstens eines ersten Leiters und wenigstens eines zweiten Leiters durch Schmutz oder Feuchtigkeit mittels der Auswerteeinrichtung detektiert wird, ein Fehlerfall erkannt wird, wobei im Fehlerfall das elektrische Gerät deaktiviert wird, eine Akkuzelle mit einer Entladeeinrichtung entladen wird oder eine Ladeeinrichtung deaktiviert wird oder ein Laden mit einer Ladeeinrichtung verhindert wird. Dadurch wird die Betriebssicherheit des elektrischen Geräts über seine Lebensdauer verbessert.

Weitere vorteilhafte Ausführungsformen ergeben sich aus der folgenden Beschreibung und der Zeichnung. In der Zeichnung zeigt:
- Fig. 1: eine schematische Darstellung eines elektrischen Geräts in einer ersten Ausführung,
- Fig. 2: eine schematische Darstellung einer ersten Schaltung,
- Fig. 3: eine schematische Darstellung eines elektrischen Geräts in einer zweiten Ausführung,
- Fig. 4: eine schematische Darstellung eines elektrischen Geräts in einer dritten Ausführung,
- Fig. 5: eine schematische Darstellung einer zweiten Schaltung,
- Fig. 6: Schritte in einem Verfahren zum Betrieb des elektrischen Geräts.

Im Folgenden werden Aspekte eines elektrischen Geräts am Beispiel eine Akku-Ladesystems beschrieben, die auch für andere elektrische Geräte einsetzbar sind.

Um elektrische Geräte ohne Abhängigkeit von einem Kraftverteilernetz zu betreiben können elektrisch aufladbare Akkuzellen verwendet werden. Um eine höhere Spannung als die einer Akkuzelle verwenden zu können ist es typisch, mehrere Akkuzellen in einem Batteriepack zu verbinden. Es gibt Elektrogeräte, die mit wechselbaren Batteriepack betrieben werden können. Damit kann ein Anwender bei leerem Batteriepack diesen einfach gegen einen vollen austauschen und unterbrechungsfrei weiterarbeiten.

Um sicher zu stellen, dass in einem Batteriepack aus mehreren Akkuzellen jede Akkuzelle in ihrer Spezifikation betrieben wird, können Batteriepacks über eigene Elektronikkomponenten verfügen, die die Zellen in Spannung und Temperatur überwachen, und je nach Betriebszustand das Laden und Entladen ermöglichen oder nicht. Hierbei werden integrierte dedizierte Schaltkreise verwendet, oder auch Mikrocontroller. Die Elektronikkomponenten können auf Leiterplatten aufgebaut sein.

Bei der Verwendung von Akkupacks vor allem in Elektrowerkzeugen, aber auch Gartengeräten oder kleinen automobilen Geräten wie E-Bikes, können die Geräte, Akkupacks und auch Lader einer schmutzigen Umgebung ausgesetzt sein. Ein Eindringen von Schmutz und/oder Feuchtigkeit in ein derartiges elektrisches Gerät kann dazu führen, dass ungewollte elektrische Verbindungen entstehen, die die Funktionalität des Geräts, Batteriepacks oder eines Ladegeräts zum Laden des Batteriepacks beeinträchtigen. In ungünstigen Fällen könnten solche Verschmutzungen und/oder Feuchtigkeit auch dazu führen, dass der sichere Betrieb eingeschränkt ist. Diese ist insbesondere der Fall, wenn eine Menge von eingedrungenem Schmutz und/oder eingedrungener Feuchtigkeit größer ist als erwartet.

Deshalb kann das elektrische Geräte derart aufgebaut sein, dass es gegen das Eindringen von Wasser und Schmutz besonders geschützt ist. Ein Schutz gegen Feuchtigkeit und Schmutz kann z.B. mit einem Verguss von Elektronikkomponenten erreicht werden.

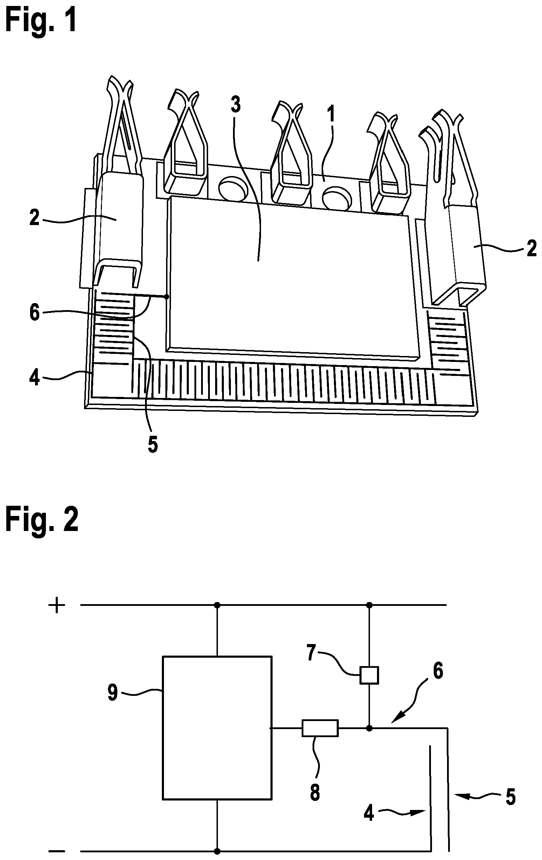

Figur 1 zeigt eine schematische Darstellung des elektrischen Geräts in einer ersten Ausführung.

Das elektrische Gerät umfasst in der ersten Ausführung eine Leiterplatte 1 mit Kontakten 2, die wenigstens eine Elektronikkomponente 3, z.B. für ein Batteriemanagement, trägt. An der Leiterplatte 1 sind im Beispiel ein erster Kontakt für ein erstes Potential und ein zweiter Kontakt für ein zweites, vom ersten Potential verschiedenes Potential angeordnet. Im Beispiel sind der erste Kontakt und der zweite Kontakt als Kontaktfedern oder Kontakttulpen ausgeführt.

Auf der Leiterplatte 1 ist die wenigstens eine Elektronikkomponente 3 angeordnet. Die Elektronikkomponente 3 kann besonders gegen Schmutz oder Feuchtigkeit geschützt sein. Beispielsweise ist die Elektronikkomponente 3 durch einen Verguss mit einem nicht leitfähigen medienbeständigen Kunststoff wie Silikon geschützt. Auf einem nicht durch den Verguss geschützten Bereich der Leiterplatte 1 befinden sich im Beispiel ein erster Leiter 4 und ein zweiter Leiter 5. Im Beispiel sind der erste Leiter 4 und der zweite Leiter 5 zwei benachbarte, gegen eine Umgebung der Leiterplatte 1 nicht isolierte Leiterbahnen. Der erste Leiter 4 und der zweite Leiter 5 kann jeweils eine Fingerstruktur aufweisen. Diese Fingerstrukturen können ineinander verschachtelt sein. Damit decken die ineinander verschachtelten Fingerstrukturen eine besonders große Fläche auf der Leiterplatte 1 ab. Der Leiter 4 und der Leiter 5 können zumindest abschnittsweise einen gleichmäßigen Abstand voneinander haben.

Der erste Leiter 4 ist diesem Beispiel mit einer der Kontakttulpen elektrisch verbunden. Die Elektronikkomponente 3 kann über eine in Figur 1 nicht dargestellte Verbindung mit dieser Kontakttulpe elektrisch verbunden sein. Die Elektronikkomponente 3 kann über eine in Figur 1 nicht dargestellte Verbindung mit der anderen der Kontakttulpen elektrisch verbunden sein.

Für den zweiten Leiter 5 ist im Beispiel eine erste Verbindung 6 zu einer ersten Schaltung für eine Detektion von Schmutz oder Feuchtigkeit vorgesehen. Die erste Schaltung ist im Beispiel in der Elektronikkomponente 3 angeordnet.

In Figur 2 ist eine schematische Darstellung der ersten Schaltung wiedergegeben. Die erste Schaltung umfasst die erste Verbindung 6, einen ersten Widerstand 7, einen zweiten Widerstand 8 und eine Auswerteeinrichtung 9. Die Auswerteeinrichtung 9 kann einen Mikrokontroller umfassen.

Der erste Leiter 4 ist in diesem Beispiel mit einem Eingang der Auswerteeinrichtung 9 für ein Bezugspotential des elektrischen Geräts elektrisch verbunden. In dem in Figur 2 dargestellten Beispiel ist ein negatives Bezugspotential als erstes Potential vorgesehen. Dieses ist im Beispiel am ersten Kontakt anlegbar.

Der zweite Leiter 5 ist in diesem Beispiel über die erste Verbindung 6 und den ersten Widerstand 7 mit einem Eingang der Auswerteeinrichtung 9 für eine Versorgungsspannung des elektrischen Geräts elektrisch verbunden. In dem in Figur 2 dargestellten Beispiel ist eine positive Versorgungsspannung als zweites Potential vorgesehen. Diese ist im Beispiel am zweiten Kontakt anlegbar.

Der zweite Leiter 5 ist in diesem Beispiel über die erste Verbindung 6 und den zweiten Widerstand 8 mit einem Eingang der Auswerteeinrichtung 9 zur Detektion von Schmutz oder Feuchtigkeit elektrisch verbunden.

Im Beispiel sind der Eingang der Auswerteeinrichtung 9 zur Detektion von Schmutz oder Feuchtigkeit und der Eingang der Auswerteeinrichtung 9 für eine Versorgungsspannung des elektrischen Geräts über den ersten Widerstand 7 und den zweiten Widerstand 8 elektrisch verbunden. Der erste Widerstand 7 ist als Pull-up Widerstand ausgelegt. Der zweite Widerstand 8 ist als Schutzwiderstand ausgelegt. Der erste Widerstand 7 und der zweite Widerstand 8 können in Reihenschaltung ausgeführt sein.

Damit ist die Auswerteeinrichtung 9 in der Lage, sehr einfach festzustellen, ob eine Verschmutzung vorliegt. Im Normalfall besteht keine Verbindung zwischen dem ersten Leiter 4 und dem zweiten Leiter 5. Die Auswerteeinrichtung 9 ist ausgebildet, an ihrem Eingang über den Widerstand 8 ein anliegendes Potential zu bestimmen. Im Beispiel wird ein hohes Potential zu messen sein, wenn keine leitfähige Verbindung zwischen dem ersten Leiter 4 und dem zweiten Leiter 5 besteht. Eine Verschmutzung stellt eine leitfähige Verbindung zwischen dem ersten Leiter 4 und dem Leiter 5 dar. Da der erste Leiter 4 im Beispiel mit dem Bezugspotenzial verbunden ist, wird das von der Auswerteeinrichtung 9 bei Verschmutzung gemessene Signal nicht mehr hoch, sondern niedrig sein.

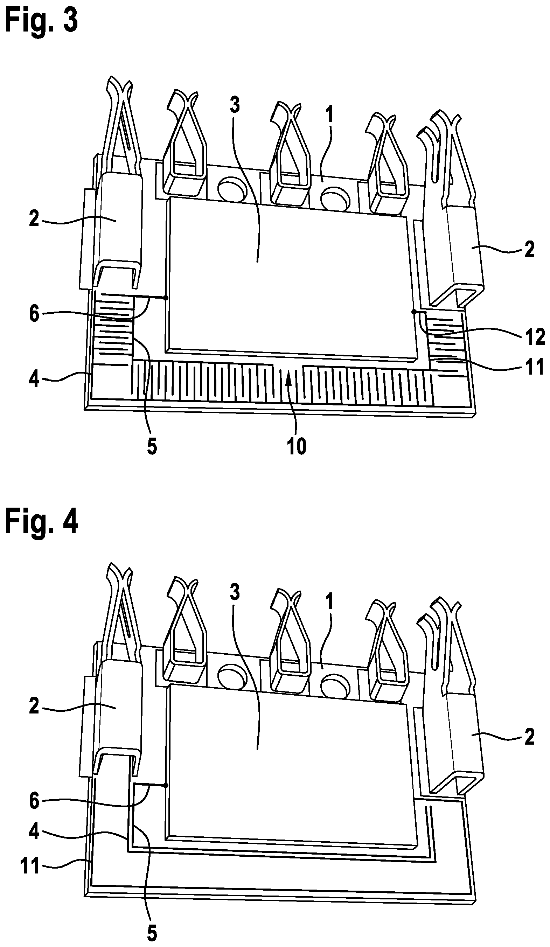

Gemäß einer in Figur 3 schematisch dargestellten zweiten Ausführung, können verschiedene Bereiche der Leiterplatte 1 getrennt überwacht werden. In Figur 3 ist ein Beispiel für zwei Bereiche dargestellt, die getrennt überwachbar sind.

Der erste Leiter 4 ist in diesem Beispiel in wie für die erste Ausführung beschrieben angeordnet. Derselbe erste Leiter 4 kann in diesem Fall für die Detektion in beiden Bereichen eingesetzt werden.

Gemäß der zweiten Ausführung sind zwei zweite Leiter vorgesehen. Einer dieser Leiter 5 ist auf einer Seite einer Unterbrechung 10, wie für die erste Ausführung beschrieben, benachbart zum ersten Leiter 4 angeordnet.

Ein anderer dieser Leiter 11 ist auf einer anderen Seite einer Unterbrechung 10, wie für die erste Ausführung beschrieben, benachbart zum ersten Leiter 4 angeordnet. Der Leiter 11 ist über eine Verbindung 12 mit der Auswerteeinrichtung 9 elektrisch verbunden. Dazu kann eine Schaltung für einen Anschluss des Leiters 11 über die Verbindung 12 an einen weiteren Eingang der Auswerteeinrichtung 9 für Detektion von Schmutz oder Feuchtigkeit vorgesehen sein. Diese kann wie für die Verbindung 6 und den Leiter 5 beschrieben ausgebildet ist. Die Auswerteeinrichtung 9 umfasst in diesem Fall zwei Eingänge zur Detektion von Schmutz oder Feuchtigkeit.

Damit ist die Auswerteeinrichtung 9 in der Lage, sehr einfach festzustellen, ob eine Verschmutzung auf einer Seite der Unterbrechung 10 auf einer anderen Seite der Unterbrechung 10 oder auf beiden Seiten der Unterbrechung 10 vorliegt. Die Auswerteeinrichtung 9 kann in diesem Fall ausgebildet sein, an beiden Eingängen ein jeweils anliegendes Potential wie zuvor beschrieben zu bestimmen.

Die Verschmutzung kann damit zuverlässig detektiert werden, wenn eine leitfähige Verschmutzung stattgefunden hat. Als Maßnahme nach einer solchen Detektion sind möglich:
- Warnung des Benutzers durch eine geeignete Anzeigevorrichtung,
- Sperren der weiteren Verwendung,
- Einschränken der weiteren Verwendung,
- Speichern des Verschmutzungsevents für etwaige Garantiebewertung.

Je nach bestimmungsgemäßer Verwendung des elektrischen Geräts ist eine geeignete Maßnahme wählbar.

Umfasst das elektrische Gerät ein Batteriepack, der vor Schmutz oder Feuchtigkeit geschützt ist, kann beispielsweise ein Sperren der weiteren Verwendung z.B. durch Deaktivieren vorgesehen sein. Ist eine Verschmutzung gemäß der bestimmungsgemäßen Verwendung erwartbar, da z.B. der Batteriepack durch interne Schutzmaßnahmen schmutztolerant konstruiert ist, kann beispielsweise eine Warnung des Benutzers vorgesehen sein.

Gemäß der zweiten Ausführung können im elektrischen Gerät verschiedene Paare von erstem Leiter 4 und zweitem Leiter 5 elektrisch isoliert voneinander angeordnet sein, die mit unterschiedlichen Eingängen der Auswerteinrichtung 9 elektrisch verbunden sind.

Die Auswerteinrichtung 9 ist in diesem Fall ausgebildet, eine Anzahl von Paaren zu bestimmen, für die die elektrische Verbindung detektiert wurde. Die Auswerteinrichtung 9 kann in diesem Fall ausgebildet sein, einen Fehlerfall des elektrischen Geräts abhängig von der Anzahl zu bestimmen.

Im elektrischen Gerät kann gemäß einer dritten Ausführung ein erster Leiter 4 und eine Mehrzahl von zweiten Leitern benachbart zueinander und elektrisch isoliert voneinander angeordnet sein. Die Auswerteinrichtung 9 ist in diesem Fall ausgebildet, eine Anzahl von zweiten Leitern zu bestimmen, für die die elektrische Verbindung des ersten Leiters 4 mit dem zweiten Leiter detektiert wird. Die Auswerteinrichtung 9 kann in diesem Fall ausgebildet sein, einen Fehlerfall des elektrischen Geräts abhängig von der Anzahl zu bestimmen.

Mit dieser Schaltung ist möglich, Bereiche getrennt voneinander zu überwachen, oder in geringem Maß Verschmutzungen zu zählen. Beispielsweise kann die Auswerteinrichtung 9 ausgebildet sein, bei entdecken eines einzelnen Partikels eine Warnung auszulösen. Beispielsweise kann die Auswerteinrichtung 9 ausgebildet sein z.B. eine Leuchtanzeige anzusteuern. Beispielsweise kann die Auswerteinrichtung 9 eine Kommunikationsschnittstelle aufweisen, und ausgebildet sein, eine Nachricht an ein vernetztes Datenendgerät zu senden. Die Nachricht kann bei entdecken eines Partikels gesendet werden. Die Auswerteeinrichtung 9 kann ausgebildet sein, einen Akkupack für eine weitere Verwendung zu sperren, wenn nachdem ein Partikel an einem zweiten Leiter entdeckt wurde, ein weiterer Partikel an einem anderen zweiten Leiter entdeckt wird.

Es kann vorgesehen sein, mehr als zwei Paare anzuordnen um es der Auswerteeinrichtung 9 zu ermöglichen, unter deren Verwendung weitere Partikel zu zählen

Den Paaren können überwachte Bereiche zugeordnet sein. Ein derartiges Unterteilen in Bereiche hat den zusätzlichen Vorteil, dass Luft- und Kriechstrecken vergrößert werden können.

In Figur 4 ist eine schematische Darstellung eines elektrischen Geräts in der dritten Ausführung für zwei zweite Leiter dargestellt, die in Figur 4 mit 5 und 11 bezeichnet sind.

Anstelle von oder zusätzlich zu der Entdeckung von Partikeln in verschiedenen Bereichen kann die Auswerteeinrichtung 9 gemäß der dritten Ausführung ausgebildet sein, Verschmutzungen verschiedener Größe zu detektieren.

In einem Aspekt der dritten Ausführung sind unterschiedlich große Abstände zwischen dem ersten Leiter 4 und dem Leiter 5 sowie dem ersten Leiter 4 und dem Leiter 11 vorgesehen. Der Abstand zwischen den dem Leiter 5 und dem Leiter 11 kann im Wesentlichen derselbe sein wie der Abstand zwischen dem ersten Leiter 4 und dem Leiter 5 oder zwischen dem ersten Leiter 4 und dem Leiter 11.

Die übrigen Komponenten der dritten Ausführung sind im Beispiel entsprechend der anhand der Figur 3 beschriebenen zweiten Ausführung ausgeführt.

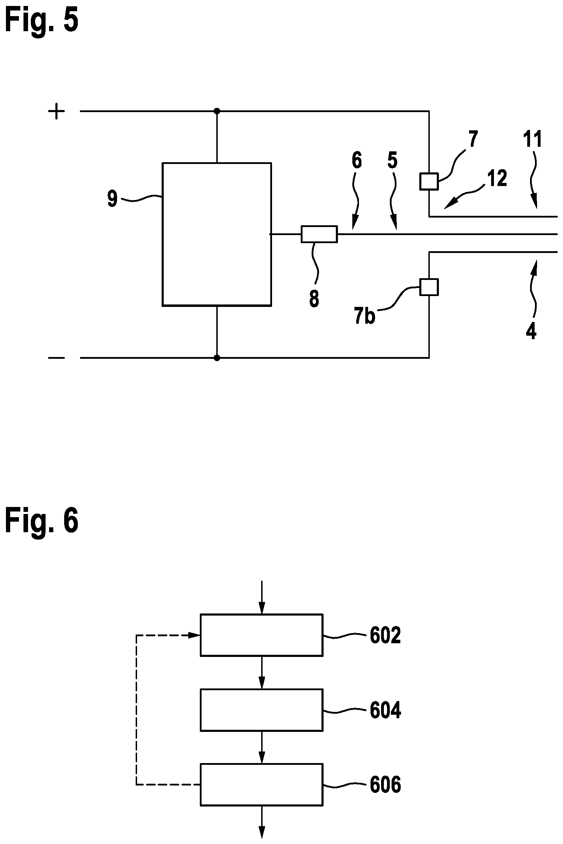

Figur 5 zeigt eine schematische Darstellung einer zweiten Schaltung für die dritte Ausführung.

Im Unterschied zur ersten Schaltung ist der erste Leiter 4 ist in diesem Beispiel über einen Widerstand 7b mit dem Eingang der Auswerteeinrichtung für das Bezugspotential elektrisch verbunden. Der Leiter 11 ist mit dem Widerstand 7 mit dem Eingang der Auswerteeinrichtung für die Versorgungsspannung elektrisch verbunden. Der Leiter 5 ist über den Widerstand 8 mit dem Eingang der Auswerteeinrichtung 9 zur Detektion von Schmutz oder Feuchtigkeit elektrisch verbunden.

Die Auswerteinrichtung 9 kann in diesem Fall ausgebildet sein, eine Anzahl von zweiten Leitern zu bestimmen, für die die elektrische Verbindung des ersten Leiters 4 mit dem zweiten Leiter detektiert wird. Die Auswerteinrichtung 9 kann in diesem Fall ausgebildet sein, einen Fehlerfall des elektrischen Geräts abhängig von der Anzahl zu bestimmen.

Statt oder zusätzlich zur Anzahl kann die Auswerteeinrichtung 9 ausgebildet sein, eine Größe oder Position der Verschmutzung oder der Feuchtigkeit abhängig von einer Kennzeichnung des Eingangs der Auswerteeinrichtung 9 zu bestimmen, an der das niedrige Potential bestimmt wurde.

Der erste Leiter 4 ist im Beispiel mit dem Bezugspotenzial verbunden. Die Auswerteeinrichtung 9 ist ausgebildet, über Leiter 5 eine elektrische Verbindung von Leiter 5 mit dem ersten Leiter 4 durch eine leitfähige Verschmutzung zu detektieren. Die Auswerteeinrichtung 9 ist ausgebildet, über Leiter 5 eine leitfähige Verschmutzung von Leiter 11 mit dem ersten Leiter 4 durch eine leitfähige Verschmutzung zu detektieren. Im Beispiel ist der Abstand zwischen dem Leiter 11 und dem ersten Leiter 4 größer als der Abstand zwischen Leiter 5 und dem ersten Leiter 4. Die Auswerteeinrichtung 9 ist ausgebildet, bei einer leitfähigen Verbindung des Leiters 11 mit dem ersten Leiter 4 eine großflächige Verschmutzung zu erkennen. Die Auswerteeinrichtung 9 ist ausgebildet, bei einer leitfähigen Verbindung des Leiters 5 mit dem ersten Leiter 4 ohne leitfähige Verbindung des Leiters 11 mit dem ersten Leiter 4 eine demgegenüber kleinflächige Verschmutzung zu erkennen.

Figur 6 stellt Schritte in einem Verfahren zum Betrieb des elektrischen Geräts schematisch dar.

In einem Schritt 602 wird geprüft, ob eine elektrische Verbindung wenigstens eines ersten Leiters 4 und wenigstens eines zweiten Leiters 5 durch Schmutz oder Feuchtigkeit mittels der Auswerteeinrichtung 9 detektiert wird.

Wenn eine elektrische Verbindung wenigstens eines ersten Leiters 4 und wenigstens eines zweiten Leiters 5 durch Schmutz oder Feuchtigkeit mittels der Auswerteeinrichtung 9 detektiert wird, wird ein Schritt 604 ausgeführt. Anderenfalls wir der Schritt 602 ausgeführt.

Im Schritt 604 wird ein Fehlerfall erkannt. Beispielsweise wird der Fehlerfall abhängig von einer erkannten Größe eines Partikels oder einer Anzahl Partikel oder abhängig von einer Anzahl betroffener Bereiche der Leiterplatte 1 erkannt.

Einem Fehlerfall ist im Beispiel eine Maßnahme zugeordnet. Als Maßnahme sind beispielsweise möglich:
- Warnung des Benutzers durch eine geeignete Anzeigevorrichtung,
- Sperren der weiteren Verwendung,
- Einschränken der weiteren Verwendung,
- Speichern des Verschmutzungsevents für etwaige Garantiebewertung.

Im Beispiel kann vorgesehen sein, das elektrische Gerät zu deaktivieren, eine Akkuzelle mit einer Entladeeinrichtung entladen, eine Ladeeinrichtung zu deaktivieren oder ein Laden einer Akkuzelle durch eine Ladeeinrichtung im Fehlerfall zu verhindern.

Je nach bestimmungsgemäßer Verwendung des elektrischen Geräts wird im Beispiel eine geeignete Maßnahme aus einer Zuordnung gewählt.

Anschließend wird ein Schritt 606 ausgeführt.

Im Schritt 606 wird die gewählten Maßnahme ausgeführt.

Beispielsweise wird der Benutzer durch die geeignete Anzeigevorrichtung gewarnt, eine weitere Verwendung des elektrischen Geräts gesperrt oder eingeschränkt, oder ein Verschmutzungsevent für etwaige Garantiebewertung gespeichert oder ein Laden mit einer Ladeeinrichtung verhindert. Im Beispiel kann vorgesehen sein, das elektrische Gerät zu deaktivieren, eine Akkuzelle mit einer Entladeeinrichtung entladen oder eine Ladeeinrichtung zu deaktivieren.

Anschließend kann der Schritt 602 zur Fortsetzung der Überwachung ausgeführt werden oder das Verfahren beendet werden.

## Patentansprüche

1. Elektrisches Gerät, das ein Gehäuse mit einem ersten außenliegenden Kontakt (2) und einem zweiten außenliegenden Kontakt (2) zur Energieversorgung des elektrischen Geräts aufweist, wobei das elektrische Gerät im Gehäuse einen ersten Leiter (4), einen zweiten Leiter (5) und eine Auswerteeinrichtung (9) umfasst, wobei der erste Leiter (4) mit einem ersten Kontakt (2) für ein erstes Potential elektrisch verbunden ist, wobei der zweite Leiter (5) mit einem zweiten Kontakt (2) für ein zweites, vom ersten Potential verschiedenes Potential elektrisch verbunden ist, wobei der erste Leiter (4) und der zweite Leiter (5) mit der Auswerteeinrichtung (9) elektrisch verbunden sind, wobei der erste Leiter (4) und der zweite Leiter (5) derart angeordnet sind, dass eine elektrische Verbindung des ersten Leiters (4) und des zweiten Leiters (5) durch Schmutz oder Feuchtigkeit im Gehäuse mittels der Auswerteeinrichtung (9) detektierbar ist, wobei der zweite Leiter (5) über einen Widerstand (8) mit einem Eingang der Auswerteeinrichtung (9) zur Detektion von Schmutz oder Feuchtigkeit elektrisch verbunden ist, wobei die Auswerteeinrichtung (9) ausgebildet ist, einen Fehlerfall zu erkennen, wenn eine elektrische Verbindung des ersten Leiters (4) und des zweiten Leiters (5) durch Schmutz oder Feuchtigkeit detektiert wurde, **dadurch gekennzeichnet, dass** die Auswerteeinrichtung (9) ausgebildet ist, das elektrische Gerät im Fehlerfall zu deaktivieren, und dass der erste Leiter (4) und der zweite Leiter (5) zwei benachbarte, gegen eine Umgebung der Leiterplatte (1) nicht isolierte Leiterbahnen sind.

2. Elektrisches Gerät nach Anspruch 1, **dadurch gekennzeichnet, dass** der zweite Leiter (5) über einen Widerstand (7) mit dem zweiten Kontakt (2) und einem Eingang der Auswerteeinrichtung (9) für eine Versorgungsspannung elektrisch verbunden ist.

3. Elektrisches Gerät nach einem der Ansprüche 1 oder 2, **dadurch gekennzeichnet, dass** der erste Leiter (4) mit einem Eingang der Auswerteeinrichtung (9) für ein Bezugspotential elektrisch verbunden ist.

4. Elektrisches Gerät nach einem der Ansprüche 1 bis 3, **dadurch gekennzeichnet, dass** der erste Leiter (4) und der zweite Leiter (5) elektrisch isoliert voneinander und in einem Bereich zumindest abschnittsweise benachbart und unisoliert zueinander angeordnet sind.

5. Elektrisches Gerät nach Anspruch 1, **dadurch gekennzeichnet, dass** das elektrische Gerät eine Akkuzelle und eine Entladeeinrichtung umfasst, wobei die Auswerteeinrichtung (9) ausgebildet ist, die Akkuzelle im Fehlerfall mit der Entladeeinrichtung zu entladen.

6. Elektrisches Gerät nach Anspruch 1, **dadurch gekennzeichnet, dass** das elektrische Gerät eine Ladeeinrichtung für eine Akkuzelle umfasst, wobei die Auswerteeinrichtung (9) ausgebildet ist, die Ladeeinrichtung im Fehlerfall zu deaktivieren oder wobei die Auswerteeinrichtung (9) ausgebildet ist, ein Laden einer Akkuzelle durch eine Ladeeinrichtung im Fehlerfall zu verhindern.

7. Elektrisches Gerät nach einem der vorherigen Ansprüche, **dadurch gekennzeichnet, dass** im elektrischen Gerät verschiedene Paare von erstem Leiter (4) und zweitem Leiter (5) elektrisch isoliert voneinander angeordnet sind, die mit unterschiedlichen Eingängen der Auswerteinrichtung (9) elektrisch verbunden sind, wobei die Auswerteinrichtung (9) ausgebildet ist, eine Anzahl von Paaren zu bestimmen, für die die elektrische Verbindung detektiert wird, wobei die Auswerteinrichtung (9) ausgebildet ist, einen Fehlerfall des elektrischen Geräts abhängig von der Anzahl zu bestimmen.

8. Elektrisches Gerät nach einem der vorherigen Ansprüche, **dadurch gekennzeichnet, dass** im elektrischen Gerät ein erster Leiter und eine Mehrzahl von zweiten Leitern benachbart zueinander und elektrisch isoliert voneinander angeordnet sind, wobei die Auswerteinrichtung (9) ausgebildet ist, eine Anzahl von zweiten Leitern zu bestimmen, für die die elektrische Verbindung des ersten Leiters (4) mit dem zweiten Leiter (5) detektiert wird, wobei Auswerteinrichtung (9) ausgebildet ist, einen Fehlerfall des elektrischen Geräts abhängig von der Anzahl zu bestimmen.

9. Verfahren zum Betrieb eines elektrischen Geräts in dem wenigstens ein erster Leiter (4), wenigstens ein zweiter Leiter (5) und eine Auswerteeinrichtung (9) angeordnet sind, wobei der wenigstens eine erste Leiter (4) mit einem Kontakt (2) für ein erstes Potential elektrisch verbunden ist, wobei der wenigstens eine zweite Leiter (5) mit einem Kontakt (2) für ein zweites, vom ersten Potential verschiedenes Potential elektrisch verbunden ist, wobei das elektrische Gerät mittels der Kontakte mit Energie versorgt wird, wobei der wenigstens eine erste Leiter (4) und der zweite Leiter (5) mit der Auswerteeinrichtung (9) elektrisch verbunden sind, wobei der wenigstens eine erste Leiter (4) und der wenigstens eine zweite Leiter (5) derart angeordnet sind, dass eine elektrische Verbindung wenigstens eines ersten Leiters (4) und wenigstens eines zweiten Leiters (5) durch Schmutz oder Feuchtigkeit mittels der Auswerteeinrichtung (9) detektierbar ist, wobei wenn eine elektrische Verbindung wenigstens eines ersten Leiters (4) und wenigstens eines zweiten Leiters (5) durch Schmutz oder Feuchtigkeit mittels der Auswerteeinrichtung (9) detektiert wird (602), ein Fehlerfall erkannt wird (604), wobei im Fehlerfall ein Benutzer durch eine Anzeigevorrichtung gewarnt, eine weitere Verwendung des elektrischen Geräts gesperrt oder eingeschränkt, ein Verschmutzungsevent für etwaige Garantiebewertung gespeichert, das elektrische Gerät deaktiviert, eine Akkuzelle mit einer Entladeeinrichtung entladen oder eine Ladeeinrichtung deaktiviert wird (606) oder ein Laden mit einer Ladeeinrichtung verhindert wird (606).

## Claims

1. Electrical device which has a housing with a first external contact (2) and a second external contact (2) for supplying power to the electrical device, wherein the electrical device comprises a first conductor (4), a second conductor (5) and an evaluation means (9) in the housing, wherein the first conductor (4) is electrically connected to a first contact (2) for a first potential, wherein the second conductor (5) is electrically connected to a second contact (2) for a second potential that is different from the first potential, wherein the first conductor (4) and the second conductor (5) are electrically connected to the evaluation means (9), wherein the first conductor (4) and the second conductor (5) are arranged in such a way that an electrical connection between the first conductor (4) and the second conductor (5) due to dirt or moisture in the housing can be detected by means of the evaluation means (9), wherein the second conductor (5) is electrically connected via a resistor (8) to an input of the evaluation means (9) for detecting dirt or moisture, wherein the evaluation means (9) is designed to identify a fault situation when an electrical connection between the first conductor (4) and the second conductor (5) due to dirt or moisture has been detected, **characterized in that** the evaluation means (9) is designed to deactivate the electrical device in the event of a fault, and **in that** the first conductor (4) and the second conductor (5) are two adjacent conductor tracks that are not insulated against an area surrounding the printed circuit board (1).

2. Electrical device according to Claim 1, **characterized in that** the second conductor (5) is electrically connected via a resistor (7) to the second contact (2) and an input of the evaluation means (9) for a supply voltage.

3. Electrical device according to either of Claims 1 and 2, **characterized in that** the first conductor (4) is electrically connected to an input of the evaluation means (9) for a reference potential.

4. Electrical device according to any of Claims 1 to 3, **characterized in that** the first conductor (4) and the second conductor (5) are arranged in a manner electrically insulated from each other and in one region adjacent to and uninsulated from each other at least in sections.

5. Electrical device according to Claim 1, **characterized in that** the electrical device comprises a battery cell and a discharge means, wherein the evaluation means (9) is designed to discharge the battery cell using the discharge means in the event of a fault.

6. Electrical device according to Claim 1, **characterized in that** the electrical device comprises a charging means for a battery cell, wherein the evaluation means (9) is designed to deactivate the charging means in the event of a fault or wherein the evaluation means (9) is designed to prevent charging of a battery cell by a charging means in the event of a fault.

7. Electrical device according to any of the preceding claims, **characterized in that** different pairs of first conductor (4) and second conductor (5) are arranged electrically insulated from each other in the electrical device, the different pairs being electrically connected to different inputs of the evaluation means (9), wherein the evaluation means (9) is designed to determine a number of pairs for which the electrical connection is detected, wherein the evaluation means (9) is designed to determine a fault situation of the electrical device depending on the number.

8. Electrical device according to any of the preceding claims, **characterized in that** a first conductor and plurality of second conductors are arranged adjacent to each other and electrically insulated from each other in the electrical device, wherein the evaluation means (9) is designed to determine a number of second conductors for which the electrical connection of the first conductor (4) to the second conductor (5) is detected, wherein the evaluation means (9) is designed to determine a fault situation of the electrical device depending on the number.

9. Method for operating an electrical device in which at least one first conductor (4), at least one second conductor (5) and an evaluation means (9) are arranged, wherein the at least one first conductor (4) is electrically connected to a contact (2) for a first potential, wherein the at least one second conductor (5) is electrically connected to a contact (2) for a second potential that is different from the first potential, wherein the electrical device is supplied with power by means of the contacts, wherein the at least one first conductor (4) and the second conductor (5) are electrically connected to the evaluation means (9), wherein the at least one first conductor (4) and the at least one second conductor (5) are arranged in such a way that an electrical connection between at least one first conductor (4) and at least one second conductor (5) due to dirt or moisture can be detected by means of the evaluation means (9), wherein a fault situation is identified (604) when an electrical connection between at least one first conductor (4) and at least one second conductor (5) due to dirt or moisture is detected (602) by means of the evaluation means (9), wherein in the event of a fault a user is warned by a display device, further use of the electrical device is blocked or restricted, a contamination event is stored for any warranty assessment, the electrical device is deactivated, a battery cell is discharged using a discharge means or a charging means is deactivated (606) or charging using a charging means is prevented (606).

## Revendications

1. Appareil électrique qui présente un boîtier comprenant un premier contact (2) situé à l'extérieur et un deuxième contact (2) situé à l'extérieur pour l'alimentation en énergie de l'appareil électrique, l'appareil électrique comprenant dans le boîtier un premier conducteur (4), un deuxième conducteur (5) et un dispositif d'évaluation (9), le premier conducteur (4) étant relié électriquement à un premier contact (2) pour un premier potentiel, le deuxième conducteur (5) étant relié électriquement à un deuxième contact (2) pour un deuxième potentiel différent du premier potentiel, le premier conducteur (4) et le deuxième conducteur (5) étant reliés électriquement au dispositif d'évaluation (9), le premier conducteur (4) et le deuxième conducteur (5) étant agencés de telle sorte qu'une connexion électrique du premier conducteur (4) et du deuxième conducteur (5) due à la présence de saletés ou d'humidité dans le boîtier est apte à être détectée par le dispositif d'évaluation (9), le deuxième conducteur (5) étant relié électriquement par l'intermédiaire d'une résistance (8) à une entrée du dispositif d'évaluation (9) pour la détection de saletés ou d'humidité, le dispositif d'évaluation (9) étant conçu pour détecter une défaillance lorsqu'une connexion électrique entre le premier conducteur (4) et le deuxième conducteur (5) a été détectée en raison de la présence de saletés ou d'humidité, **caractérisé en ce que** le dispositif d'évaluation (9) est conçu pour désactiver l'appareil électrique en cas de défaillance, et **en ce que** le premier conducteur (4) et le deuxième conducteur (5) sont deux pistes conductrices adjacentes non isolées par rapport à l'environnement de la carte à circuit imprimé (1).

2. Appareil électrique selon la revendication 1, **caractérisé en ce que** le deuxième conducteur (5) est relié électriquement, par l'intermédiaire d'une résistance (7), au deuxième contact (2) et à une entrée du dispositif d'évaluation (9) pour une tension d'alimentation.

3. Appareil électrique selon l'une des revendications 1 ou 2, **caractérisé en ce que** le premier conducteur (4) est relié électriquement à une entrée du dispositif d'évaluation (9) pour un potentiel de référence.

4. Appareil électrique selon l'une des revendications 1 à 3, **caractérisé en ce que** le premier conducteur (4) et le deuxième conducteur (5) sont isolés électriquement l'un de l'autre, et, dans une zone, sont agencés au moins partiellement adjacents l'un à l'autre et non isolés l'un de l'autre.

5. Appareil électrique selon la revendication 1, **caractérisé en ce que** l'appareil électrique comprend une cellule d'accumulateur et un dispositif de décharge, le dispositif d'évaluation (9) étant conçu pour décharger la cellule d'accumulateur avec le dispositif de décharge en cas de défaillance.

6. Appareil électrique selon la revendication 1, **caractérisé en ce que** l'appareil électrique comprend un dispositif de charge pour une cellule d'accumulateur, le dispositif d'évaluation (9) étant conçu pour désactiver le dispositif de charge en cas de défaillance ou le dispositif d'évaluation (9) étant conçu pour empêcher le chargement d'une cellule d'accumulateur par un dispositif de charge en cas de défaillance.

7. Appareil électrique selon l'une des revendications précédentes, **caractérisé en ce que**, dans l'appareil électrique, différentes paires de premier conducteur (4) et de deuxième conducteur (5) sont agencées de manière électriquement isolée les unes des autres, qui sont reliées électriquement à différentes entrées du dispositif d'évaluation (9), le dispositif d'évaluation (9) étant conçu pour déterminer un nombre de paires pour lesquelles la connexion électrique est détectée, le dispositif d'évaluation (9) étant conçu pour déterminer un cas de défaillance de l'appareil électrique en fonction du nombre.

8. Appareil électrique selon l'une des revendications précédentes, **caractérisé en ce que**, dans l'appareil électrique, un premier conducteur et une pluralité de deuxièmes conducteurs sont agencés de manière adjacente les uns aux autres et isolés électriquement les uns des autres, le dispositif d'évaluation (9) étant conçu pour déterminer un nombre de deuxièmes conducteurs pour lesquels la connexion électrique du premier conducteur (4) au deuxième conducteur (5) est détectée, le dispositif d'évaluation (9) étant conçu pour déterminer un cas de défaillance de l'appareil électrique en fonction du nombre.

9. Procédé pour faire fonctionner un appareil électrique dans lequel sont agencés au moins un premier conducteur (4), au moins un deuxième conducteur (5) et un dispositif d'évaluation (9), ledit au moins un premier conducteur (4) étant relié électriquement à un contact (2) pour un premier potentiel, ledit au moins un deuxième conducteur (5) étant relié électriquement à un contact (2) pour un deuxième potentiel différent du premier potentiel, l'appareil électrique étant alimenté en énergie au moyen des contacts, ledit au moins un premier conducteur (4) et ledit au moins un deuxième conducteur (5) étant reliés électriquement au dispositif d'évaluation (9), ledit au moins un premier conducteur (4) et ledit au moins un deuxième conducteur (5) étant agencés de telle sorte qu'une connexion électrique d'au moins un premier conducteur (4) et d'au moins un deuxième conducteur (5) due à la présence de saletés ou d'humidité soit apte à être détectée par le dispositif d'évaluation (9) ; lorsqu'une connexion électrique d'au moins un premier conducteur (4) et d'au moins un deuxième conducteur (5) est détectée (602) par le dispositif d'évaluation (9) en raison de la présence de saletés ou d'humidité, un cas d'erreur est reconnu (604), en cas d'erreur, un utilisateur est averti par un dispositif d'affichage, l'utilisation ultérieure de l'appareil électrique est bloquée ou restreinte, un événement d'encrassement est enregistré pour une éventuelle évaluation de la garantie, l'appareil électrique est désactivé, une cellule d'accumulateur est déchargée en utilisant un dispositif de décharge ou un dispositif de charge est désactivé (606) ou un chargement en utilisant un dispositif de charge est empêché (606).
